(19) **Europäisches Patentamt / European Patent Office / Office européen des brevets**

(11) **EP 1 614 008 B1**

(12) **EUROPÄISCHE PATENTSCHRIFT**

(45) Veröffentlichungstag und Bekanntmachung des Hinweises auf die Patenterteilung:
**02.12.2009 Patentblatt 2009/49**

(21) Anmeldenummer: **04726991.5**

(22) Anmeldetag: **13.04.2004**

(51) Int Cl.:
**G03F 7/20** (2006.01)

(86) Internationale Anmeldenummer:
**PCT/EP2004/003855**

(87) Internationale Veröffentlichungsnummer:
**WO 2004/092844 (28.10.2004 Gazette 2004/44)**

(54) **OPTISCHES ELEMENT FÜR EIN BELEUCHTUNGSSYSTEM**

OPTICAL ELEMENT FOR A LIGHTING SYSTEM

ELEMENT OPTIQUE POUR SYSTEME D ECLAIRAGE

(84) Benannte Vertragsstaaten:
**DE IT NL**

(30) Priorität: **17.04.2003 DE 10317667**

(43) Veröffentlichungstag der Anmeldung:
**11.01.2006 Patentblatt 2006/02**

(73) Patentinhaber: **Carl Zeiss SMT AG
73447 Oberkochen (DE)**

(72) Erfinder:
• **SINGER, Wolfgang
73431 Aalen (DE)**
• **ANTONI, Martin
73431 Aalen (DE)**

(74) Vertreter: **Sawodny, Michael-Wolfgang
Dreiköniggasse 10
89073 Ulm (DE)**

(56) Entgegenhaltungen:
**EP-A- 0 627 667     WO-A-01/69321
US-A- 5 339 346**

• **CHAPMAN H N ET AL: "NOVEL CONDENSER FOR EUV LITHOGRAPHY RING-FIELD PROJECTION OPTICS" PROCEEDINGS OF THE SPIE, SPIE, BELLINGHAM, VA, US, Bd. 3767, 1999, Seiten 225-236, XP000938184 ISSN: 0277-786X**

**Beschreibung**

Die Erfindung betrifft ein optisches Element für ein Beleuchtungssystem mit Wellenlängen ≤ 193 nm, insbesondere für die EUV-Lithographie, wobei das Beleuchtungssystem eine Lichtquelle, eine Feldebene sowie eine Austrittspupille umfaßt und das Beleuchtungssystem eine Vielzahl von Facetten aufweist.

In einer besonders bevorzugten Ausführungsform stellt die Erfindung ferner ein Beleuchtungssystem für Wellenlängen ≤ 193 nm, insbesondere für die EUV-Lithographie zur Verfügung; das sich dadurch auszeichnet, daß das optische Element eine Vielzahl von Facetten aufweist, wobei die Facetten auf dem optischen Element eine derartige Anordnung aufweisen, daß mit diesem optischen Element ein Feld in der Feldebene sowie die Austrittspupille in einer vorbestimmten Form ausgeleuchtet werden.

Um die Strukturbreiten für elektronische Bauteile noch weiter reduzieren zu können, insbesondere in den Submikron-Bereich, ist es erforderlich, die Wellenlänge des für die Mikrolithographie eingesetzten Lichtes zu verringern. Denkbar ist bei Wellenlängen kleiner als 193 nm beispielsweise die Lithographie mit weichen Röntgenstrahlen, die sogenannte EUV-Lithographie.

Ein für die EUV-Lithographie geeignetes Beleuchtungssystem soll mit möglichst wenigen Reflektionen das für die EUV-Lithographie vorgegebene Feld, insbesondere ein Ringfeldsegment, homogen, d.h. uniform, ausleuchten, des weiteren soll die Austrittspupille für jeden Feldpunkt nach dem Scanvorgang bis zu einem bestimmten Füllgrad σ ausgeleuchtet werden und die Austrittspupille des Beleuchtungssystems in der Eintrittspupille des nachfolgenden Objektivs liegen.

Aus der US 5,339,346 ist ein Beleuchtungssystem für eine Lithographieeinrichtung, die EUV-Strahlen verwendet, bekanntgeworden. Zur gleichmäßigen Beleuchtung in der Retikelebene und Füllung der Pupille schlägt die US 5,339;346 einen Kondensor vor, der als Kollektorlinse aufgebaut ist und wenigstens vier paarweise Spiegelfacetten, die symmetrisch angeordnet sind, umfaßt. Als Lichtquelle wird eine Plasma-Lichtquelle verwendet.

In der US 5,737,137 ist ein Beleuchtungssystem mit einer Plasma-Lichtquelle, umfassend einen Kondensorspiegel, gezeigt, bei dem mit Hilfe von sphärischen Spiegeln eine Ausleuchtung einer zu beleuchtenden Maske bzw. eines Retikels erzielt wird. Bei diesem Beleuchtungssystem handelt es sich um ein Beleuchtungssystem mit kritischer Beleuchtung.

Die US 5,361,292 zeigt ein Beleuchtungssystem, bei dem eine Plasma-Lichtquelle vorgesehen ist und die punktförmige Plasma-Lichtquelle mit Hilfe eines Kondensors, der fünf asphärische, außermittig angeordnete Spiegel aufweist, in eine ringförmig ausgeleuchtete Fläche abgebildet wird. Mit Hilfe einer speziellen nachgeordneten Abfolge von grazing-incidence Spiegeln wird die ringförmig ausgeleuchtete Fläche dann in die Eintrittspupille abgebildet.

Aus der US 5,581,605 ist ein Beleuchtungssystem bekannt geworden, bei dem ein Photonenstrahler mit Hilfe eines Wabenkondensors in eine Vielzahl von sekundären Lichtquellen aufgespalten wird. Hierdurch wird eine gleichmäßige bzw. uniforme Ausleuchtung in der Retikelebene erreicht. Die Abbildung des Retikels auf den zu belichtenden Wafer erfolgt mit Hilfe einer herkömmlichen Reduktionsoptik. Im Beleuchtungsstrahlengang ist genau ein gerasterter Spiegel mit gleich gekrümmten Elementen vorgesehen.

Aus der US 4,195,913 ist ein facettiertes Spiegelelement bekannt, bei dem die Facetten derart auf der Spiegeloberfläche angeordnet sind, daß sich die Vielzahl der von den Facetten reflektierten Lichtbündel in einer Ebene überlagern, so daß sich eine weitgehend gleichmäßige Energieverteilung in dieser Ebene ergibt. Eine bestimmte Form hat das Feld in der Ebene nicht.

Die US 4,289,380 zeigt einen einstellbaren facettierten Spiegel, der eine Vielzahl von rechteckigen Blocksegmenten umfaßt, die gegeneinander verkippt werden, so daß sich die vom Spiegel reflektierten Lichtbüschel in einer Ebene überlagern. Wie bei der US 4,195,913 wird keine Aussage darüber gemacht, wie das Feld in der Ebene aussieht.

Aus der US 4,202,605 ist ein aktiver, segmentierter Spiegel bekanntgeworden, der gekühlte hexagonale Facetten umfaßt.

Zum Sammeln des Lichtes einer EUV-Strahlungsquelle, insbesondere der einer Synchotron-Strahlungsquelle, schlägt die US 5,485,498 einen Kollektorspiegel vor, der eine Vielzahl von als Planspiegeln ausgelegten Facetten umfaßt, die derart angeordnet sind, daß die Quellstrahlung der EUV-Strahlungsquelle in ein paralleles Bündel umgelenkt wird.

Aus der DE 199 03 807 A1 und korrespondierenden US 6,198,793 ist ein EUV-Beleuchtungssystem bekanntgeworden, das zwei Spiegel oder Linsen mit Rasterelementen umfaßt. Derartige Systeme werden auch als doppelt facettierte EUV-Beleuchtungssysteme bezeichnet.

In der DE 199 03 807 A1 ist der prinzipielle Aufbau eines doppelt facettierten EUV-Beleuchtungssystems gezeigt. Die Ausleuchtung in der Austrittspupille des Beleuchtungssystems gemäß der DE 199 03 807 wird durch die Anordnung der Rasterelemente auf dem zweiten Spiegel bestimmt.

Ein doppelt facettiertes Beleuchtungssystem ist auch aus der EP-A-1026547 bekannt geworden. Die EP-A-1262836 zeigt ein reflektives optisches Element mit einer Vielzahl von Spiegelelementen, wobei die Vielzahl von Spiegelelementen einen kollimierten Strahl in eine Vielzahl von Einzelstrahlen aufspaltet und ablenkt.

Die EP-A-1024408 schlägt ein EUV-Beleuchtungssystem vor, das wenigstens zwei nicht abbildende optische Elemente aufweist. Hierbei sammelt ein erstes nicht abbildendes optisches Element das Licht der Lichtquelle und stellt eine vorbestimmte Lichtverteilung zur Ausleuchtung der Ausgangspupille des EUV-Beleuchtungssystems zur Verfügung, wobei diese beispielsweise in der Form eines Kreisrings vorliegen kann. Dieser Kollektor erzeugt somit kein Bild der Lichtquelle im endlichen.

Das zweite nicht abbildende optische Element nimmt das Licht der Lichtquelle auf, wobei dieser eine so geformte Grundform aufweist, daß das Licht in im wesentlichen in der Form ebener oder sphärischer Wellen abgestrahlt wird. Dabei ist die Grundform des zweiten optischen Elements so gestaltet, daß die Lichtquelle durch die Kombination des ersten und des zweiten optischen Elements in eine konjugierte Ebene, die entweder im unendlichen oder im endlichen liegt, abgebildet wird.

Das zweite nicht abbildende optische Element dient gemäß der EP-A-1024408 ausschließlich der Feldformung und umfaßt eine Vielzahl von Facetten bzw. Rasterelementen, die der Grundform des zweiten optischen Elements überlagert sind, um in der Feldebene eine gleichmäßige Ausleuchtung zur Verfügung zu stellen. Diese Facetten werden vorzugsweise mit einer Flächengröße von 4 bis 10 $\mu m^2$ ausgebildet und sind in der Nähe der. Ebene, welche durch die Eingangspupille des EUV-Beleuchtungssystems festgelegt wird, angeordnet.

Nachfolgend zu den beiden genannten, nicht abbildenden optischen Elementen, werden in der EP-A-1024408 zusätzlich zwei optische Elemente zwischen diesem zweiten nicht abbildenden Element und der Feldebene angeordnet, um die gewünschte Feldausformung zu erzielen. Da jedes zusätzliche optische Element einen erhöhten Lichtverlust bedeutet, insbesondere wenn aufgrund der kleinen Wellenlängen reflektive Optiken eingesetzt werden, ist die in der EP-A-1024408 vorgeschlagene Lösung wegen der Vielzahl der optischen Komponenten nachteilig.

Des weiteren sind in der EP-A-1 024408 keinerlei Angaben darüber gemacht, wie die Ablenkwinkel und Anordnung der Facetten auf dem zweiten nicht abbildenden optischen Element zu wählen sind, um das Ringfeldsegment in der Feldebene zu formen.

Ein weiterer Nachteil der EP-A-1024408 ist, daß stets zwei nicht abbildende optische Elemente, nämlich ein Kollektor und ein feldformendes Element, benötigt werden, um eine Lichtverteilung in der Austrittspupille zur Verfügung zu stellen und das Feld in der Feldebene auszuleuchten.

EP 1 072 957 A2 offenbart ein optisches Element zur Ausleuchtung eines Felds in einer Feldebene, das eine Vielzahl Facetten aufweist. Das optische Element weisst eine Pyramidenform auf und wird zur Erzeugung von Lichtquellenbildern in einer Pupillenebene eines Beleuchtungssystems und einer Intensitätsüberlagerung in der Feldebene eines EUV-Beleuchtungssystems eingesetzt.

Aufgabe der Erfindung ist es, die Nachteile des Standes der Technik zu überwinden, insbesondere soll die Anzahl der Komponenten eines EUV-Beleuchtungssystems reduziert und die Lichtverluste minimiert werden.

Die Erfinder haben nun überraschenderweise erkannt, daß bei einem optischen Element, das eine Vielzahl von Facetten umfaßt, die Anordnung und die Ablenkwinkel der Facetten auf dem optischen Element so gewählt werden können, daß mit diesem optischen Element sowohl ein Feld in der Feldebene wie auch die Austrittspupille eines Beleuchtungssystems in einer vorbestimmten Weise ausgeleuchtet werden.

In einem weiteren Aspekt der Erfindung wird ein Beleuchtungssystem das einen sehr geringen Lichtverlust hat mit einer derartigen Komponente angegeben.

Erfindungsgemäß ist es möglich ein Beleuchtungssystem mit einer einzigen derartigen facettierten optischen Komponente anzugeben, wobei die Lichtquelle oder ein Bild der Lichtquelle vielfach im wesentlichen in die Feldebene abgebildet wird und mit diesem einen einzigen optischen Element auch die Pupille des Beleuchtungssystems ausgeleuchtet wird.

Das auszuleuchtende Feld in der Feldebene kann ein Ringfeldsegment sein, wobei bei einem Scanning-Beleuchtungssystem die radiale Richtung in der Mitte des Ringfeldsegments die Scanrichtung des Beleuchtungssystems definiert.

Bei einem Beleuchtungssystem mit einem erfindungsgemäßen optischen Element kann die Ringfeldformung auch durch das optische Element selbst erfolgen.

In einem derartigen Fall kann auf die feldformende optische Komponente verzichtet werden.

Die Ausleuchtung des Ringfeldsegments kann auch über ein feldformendes optisches Element erfolgen. Das facettierte optische Element weist dann einen einfachen Aufbau auf. Zur Vermeidung von Lichtverlusten wird zur Feldformung bevorzugt ein grazing-incidence Spiegel verwendet. Bei einem grazing-incidence Spiegel müssen hinreichend große Einfallswinkel zur Flächennormalen vorliegen; die größer als 60° und bevorzugt größer als 70° eingestellt werden. Ferner kann eine Abbildungsoptik, die das facettierte optische Element in die Austrittspupille des Beleuchtungssystems abbildet, vorgesehen sein.

Die Verwendung bzw. das Entfallen von zusätzlichen optischen Komponenten wie feldformenden und/oder abbildenden optischen Elementen im Beleuchtungssystem wirkt sich nur auf die Anordnung und den Ablenkwinkel der Facetten des erfindungsgemäßen facettierten optischen Elementes aus, so daß durch den Einsatz eines derartigen Elementes EUV-Beleuchtungssysteme sehr flexibel gestaltet werden können.

Das erfindungsgemäße Beleuchtungssystem ist vorzugsweise als kritisches Beleuchtungssystem ausgebildet.

Unter einem kritischen Beleuchtungssystem wird ein solches verstanden, das die Lichtquelle oder ein Bild der Lichtquelle im wesentlichen in die Feldebene abbildet. Hiervon ausgehend werden Anordnung und Ablenkwinkel der Facetten auf dem erfindungsgemäßen optischen Element vorzugsweise mit der Gitternetztransformation bestimmt, wie nachfolgend beschrieben.

Bei einer Gitternetztransformation wird zunächst jede zu einem Feldpunkt gehörende Pupille durch ein Netzgitter repräsentiert. Entsprechend der Ausdehnung der Lichtquellen, welche in die Feldebene des Beleuchtungssystems abgebildet werden, und unter Berücksichtigung der Telezentrieanforderung wird eine Anzahl von diskreten Feldpunkten gewählt, mit denen in der Feldebene im Ringfeldsegment eine weitgehend gleichmäßige Beleuchtungsintensität erzielt wird. Sodann wird das Netzgitter der Pupillen über jeden Feldpunkt in die Ebene des optischen Elementes zurückverfolgt, so daß in der Ebene des optischen Elementes ein Facettennetz entsteht. In der Ebene des optischen Elementes wird ein Transformationsnetz berechnet, für welches die Bedingung einer gleichen Strahlungsstärke pro Zelle erfüllt ist. Sodann wird das Facettennetz auf das Transformationsnetz gelegt und beide Netze derart transformiert, daß das Transformationsnetz ein kartesisches, d.h. ein äquidistantes und rechtwinkliges Netz wird. Um jeden Gitterpunkt des transformierten Facettennetzes wird eine Facette gezogen, deren Größe durch den maximal erlaubten Abstand zum nächsten Gitterpunkt bestimmt wird. Nachfolgend wird das Facettennetz auf dem Transformationsnetz wieder zurücktransformiert. In dem zuletzt erhaltenen Facettennetz sind dann die Neigungswinkel der einzelnen Facetten durch die zugeordneten Feldpunkte definiert. In einer weitergebildeten Ausführungsform kann vorgesehen sein, daß, um einen minimalen Lichtverlust zu erreichen, eine Optimierung der Netzpunkte in der Pupille und dem Feld vorgenommen wird.

Wie zuvor beschrieben zeichnet sich ein Beleuchtungssystem mit einem nicht abbildenden optischen Element gemäß der Erfindung gegenüber dem Stand der Technik in Form der EP-A-1024408 durch verminderte Lichtverluste aus.

Im Gegensatz zu dem aus der EP-A-1024408 bekannten Beleuchtungssystem weist das erfindungsgemäße Beleuchtungssystem nur ein einziges facettiertes optisches Element auf, das sowohl das Feld in der Feldebene wie auch die Austrittspupille in einer vorbestimmten Form, beispielsweise annular, quadrupolar oder kreisförmig ausleuchtet. Bei einem derartigen facettierten optischen Element weisen die Facetten auf dem optischen Element eine derartige Anordnung und einen derartigen Ablenkwinkel auf, daß sowohl das Feld in der Feldebene wie die Austrittspupille in einer vorbestimmten Form ausgeleuchtet werden.

Ein solches Element wird auch als spekularer Reflektor bezeichnet. Es zeichnet sich dadurch aus, daß eine einfallende Welle an bestimmten Orten des Reflektors nur in bestimmte Winkel reflektiert wird. Eine Lagefestsetzung des spekularen Reflektors, beispielsweise auf die Ebene der Eingangspupille des Beleuchtungssystems, ist nicht notwendig, so daß in bezug auf die Bauraumgestaltung des erfindungsgemäßen Beleuchtungssystems keine Einschränkungen vorliegen.

Der spekulare Reflektor gemäß der Erfindung wird bevorzugt in einem kritischen Beleuchtungssystem eingesetzt. Gemäß Lexikon der Optik, herausgegeben von Heinz Haferkorn, Leipzig, 1990, S. 192, ist eine kritische Beleuchtung eine Beleuchtung, bei der die Lichtquelle oder ein Bild der Lichtquelle im wesentlichen direkt in das Objekt, das im vorliegenden Fall die Feldebene ist, abgebildet wird.

In einer besonders bevorzugten Ausführungsform weisen die Facetten auf dem optischen Element eine hexagonale Anordnung auf.

Im Lichtweg zwischen dem optischen Element und der Feldebene können ein oder mehrere feldformende optische Elemente oder optische Elemente mit abbildender Wirkung vorgesehen sein. Auch das Einbringen mehrerer optischer Elemente unter Bildung eines Zwischenbildes des Ringfeldsegments für den Einsatz von Blenden wäre möglich. Auch ist es möglich, dass das einzige facettierte optische Element ein Bild einer Lichtquelle, das sogenannte Zwischenbild im wesentlichen vielfach in die Feldebene abbildet. Ein Zwischenbild einer Lichtquelle kann beispielsweise mit Hilfe einer Kollektoreinheit ausgebildet werden. Die Kollektoreinheit nimmt das Licht der Lichtquelle auf und bildet es in ein Zwischenbild ab. Als Kollektoren sind insbesondere grazing incidence-Kollektoren, beispielsweise genestete Kollektoren wie in der US-2003-0043455 A1 beschrieben, deren Offenbarungsgehalt vollumfänglich in die vorliegende Anmeldung mitaufgenommen wird, geeignet.

Um verschiedene Beleuchfiungs-Settings, beispielsweise ein dipolares oder annulares oder quadrupolares Beleuchtungs-Setting, in der Austrittspupille des Beleuchtungssystems einzustellen bzw. verschiedene Ringfeldsegmente zu erzeugen, kann vorgesehen sein, das optische Element austauschbar, beispielsweise in einer Wechseltrommel, zu gestalten. Alternativ ist es möglich einzelne facettierte Elemente auszublenden, wenn beispielsweise anstelle eines quadropolaren Settings ein dipolares Setting eingestellt werden soll. Umgekehrt kann anstelle eines dipolaren Settings ein quadropolares Setting dadurch eingestellt werden, dass bestimmte Facetten des optischen Elementes eingeblendet werden. Besonders bevorzugt sind sogenannte polare Beleuchtungssettings, insbesondere ein dipolares oder ein quadropolares Beleuchtungssetting.

Betreffend die Einstellung unterschiedlicher Beleuchtungs-Settings wird auf die Deutsche Patentanmeldung 100 53 587.9, oder das parallele erteilte US-Patent 6,658,084 verwiesen.

Besonders vorteilhaft ist es, wenn man zur Kompensation einer ungleichmäßigen Beleuchtungsstärke der Lichtquelle die einzelnen Facetten des optischen Elementes mit Brechkraft ausstattet. Auf diese Art und Weise können in der Austrittspupille des Beleuchtungssystems in etwa gleich groß ausgeleuchtete Punkte erhalten werden. Im Feld erhält man bei einer derartigen Anordnung eine Verwaschung der kritischen Beleuchtung, was aber unerheblich ist, solange der Feldbereich nicht überstrahlt wird und keine Leistung verloren geht.

Die einzelnen Facetten können sowohl positive optische Brechkraft wie auch negative optische Brechkraft aufweisen.

Mögliche Herstellungsverfahren für die nicht abbildenden optischen Elemente sind die Grautonlithographie oder direkt schreibende Lithographie in Verbindung mit Ätztechniken, das Zusammensetzen des Elementes aus vielen kleinen Stäben, welche entsprechende Neigungswinkel an der Stirnseite aufweisen sowie das galvanische Abformen eines mit Hilfe der Grautonlithographie oder der direkt schreibenden Lithographie hergestellten Grundmusters.

Die Erfindung soll nachfolgend anhand der Zeichnungen beispielhaft beschrieben werden:

Es zeigen:

Figur 1:        das Prinzip eines spekularen Reflektors für eine homozentrische Pupille
Figur 2:        das Prinzip eines spekularen Reflektors für eine nicht homozentrische Pupille
Figur 3:        ringförmiges Feld in der Feldebene eines Beleuchtungssystems
Figur 4:        ein Pupillennetz für einen Feldpunkt
Figur 5:        das ausgeleuchtete Ringfeldsegment mit darin angeordneten Feldpunkten
Figur 6:        das Facettennetz in der Ebene des nicht abbildenden optischen Elementes
Figur 7:        das Facettennetz, das sich bei Zugrundelegen einer homogenen Beleuchtung ergibt
Figur 8:        Beleuchtungssystem mit einem spekularen Reflektor als einzige optische Komponente
Figur 9:        Projektionsbelichtungsanlage mit einem Beleuchtungssystem gemäß Figur 8
Figur 10        Beleuchtungssystem mit einem spekularen Reflektor und einem feldformenden Element
Figur 11        Projektionsbelichtungsanlage mit einem Beleuchtungssystem gemäß Figur 10
Figur 12        Beleuchtungssystem mit einem spekularen Reflektor und einem abbildenden Element
Figur 13        Projektionsbelichtungsanlage mit einem Beleuchtungssystem mit einem abbildenden und einem feldformenden Spiegel
Figur 14:       eine Projektionsbelichtungsanlage wie in Figur 13 mit einem grazing-incidence-Kollektor
Figur 15:       eine Projektionsbelichtungsanlage wie in Figur 11 mit einem 8-Spiegel-Projektionsobjektiv
Figur 16A:      spekularen Reflektor mit hexagonaler Anordnung der Facetten auf dem Spiegel
Figur 16B:      Ausschnitt eines Facettenspiegels gemäß Figur 16A

Mit dem erfindungsgemäßen optischen Element soll ein in einer Feldebene fokussiertes Büschel so abgelenkt werden, daß in der Feldebene ein Ringfeldsegment geformt wird, als auch - betrachtet von einem bestimmten Feldpunkt - beispielsweise eines Ringfeldsegmentes - aus - eine Rupille beispielsweise eines Beleuchtungssystemes in einer vorgegeben Form, beispielsweise annular oder quadrupolar, ausgeleuchtet wird.

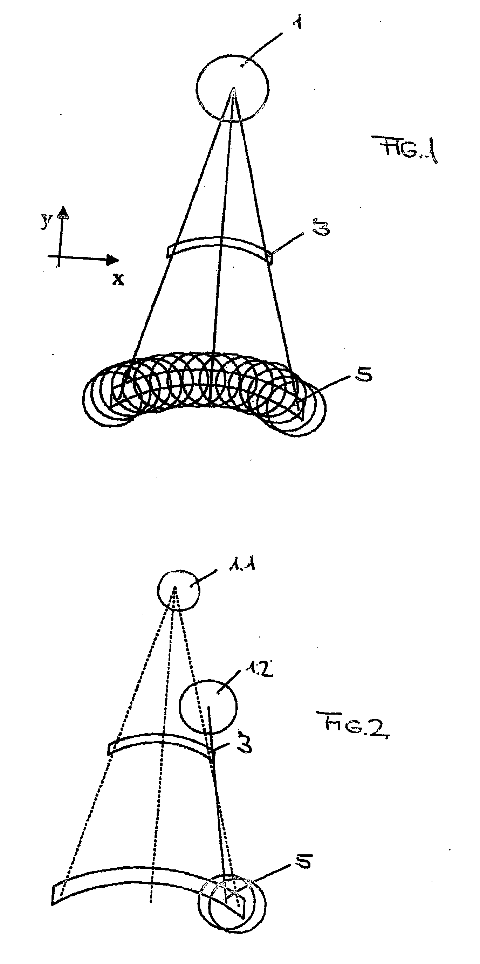

Hierzu wird in die zu einem Feldpunkt des Feldes eines Beleuchtungssystems gehörende Pupille des Beleuchtungssystems eine bestimmte Menge des einfallenden Lichtes gelenkt. Dies kann zum Beispiel durch kleine Planfacetten erfolgen. Die Planfacetten werden dabei so angeordnet, daß das Feld in der Feldebene homogen ausgeleuchtet wird und für jeden Feldpunkt eine homogen gefüllte Pupille geformt wird, i.e. die Pupille mit diskreten, aber gezielt verteilten "Punkten" gefüllt wird. In Figur 1 ist dieses Prinzip, das auch als Prinzip des spekularen Reflektors bezeichnet wird, für eine homozentrische Pupille, d.h. die Pupillenlage ist für alle Feldpunkte des Feldes, nur des Ringfeldsegmentes 3 identisch, gezeigt.

Die Pupille 1 wird durch diskrete Punkte des Ringfeldsegment 3 zum Beispiel in eine Ebene 5 zurückprojiziert. Ohne dazwischengeschaltete optische Elemente, wie zum Beispiel einen feldformenden Spiegel, ergibt sich in der Ebene 5 eine nierenförmige Ausleuchtung, die im wesentlichen der Form des Ringfeldes entspricht. In der Region der Ausleuchtung werden kleine Facettenspiegel in der Ebene 5 nun so angeordnet, daß sie sowohl die diskreten Punkte im Ringfeldsegment 3 als auch die zugeordneten Pupillen 1 homogen ausleuchten.

Des weiteren eingezeichnet in Figur 1 ist das x-y-Koordinatensystem. Bei einem Ringfeldscanner ist die y-Richtung die Scanrichtung und die x-Richtung steht senkrecht auf der Scanrichtung.

In Figur 2 ist das Prinzip des spekularen Reflektors für beliebige Eintrittspupillen, d.h. nicht homozentrische, sondern feldabhängige Pupillenlagen 1.1, 1.2 gezeigt. Es ergibt sich lediglich eine andere Überlagerung der rückprojizierten Pupillen in der Ebene 5

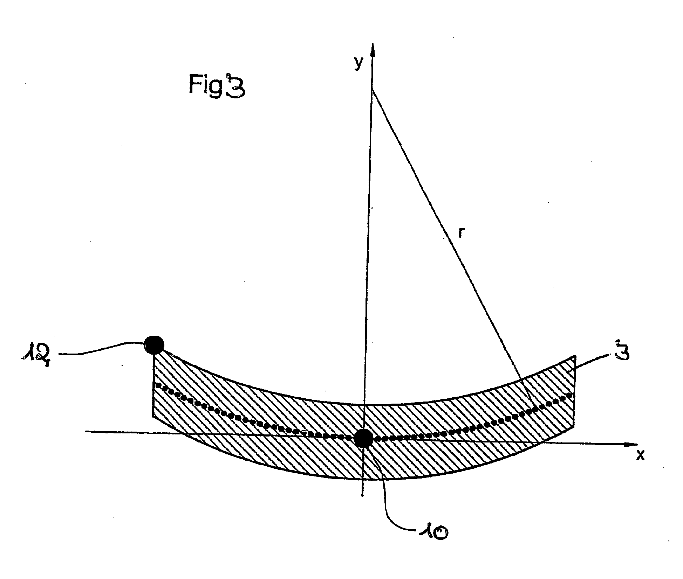

In Figur 3 ist das Ringfeldsegment 3 in der Feldebene des Beleuchtungssystems mit einem kartesischen Koordinatensystem umfassend eine x- und eine y- Richtung gezeigt. Die Bezugsziffer 10 bezeichnet einen Feldpunkt in der Mitte des Ringfeldsegments, die Bezugsziffer 12 einen Feldpunkt am Rand des Ringfeldsegments. Die y-Richtung ist bei einem Ringfeldscanner die Scanrichtung des Beleuchtungssystems; die x-Richtung die Richtung die senkrecht auf der Scanrichtung steht. Der Abstand vom Feldpunkt in der Mitte des Ringfeldsegments 10 in x-Richtung wird als Feldhöhe x bezeichnet.

Da herkömmliche Lichtquellen ausgedehnt sind, d.h. das nicht abbildende optische Element an jedem Ort mit einer bestimmten Winkeldivergenz ausgeleuchtet wird, ist es möglich, auch nur bei einer Beschränkung auf die Auswahl endlich vieler diskreter Feldpunkte eine homogene Ausleuchtung in der Feldebene zu erzielen.

Die Anordnung der Facetten und deren Ablenkwinkel können mit Methoden der Gitternetztransformation bestimmt werden.

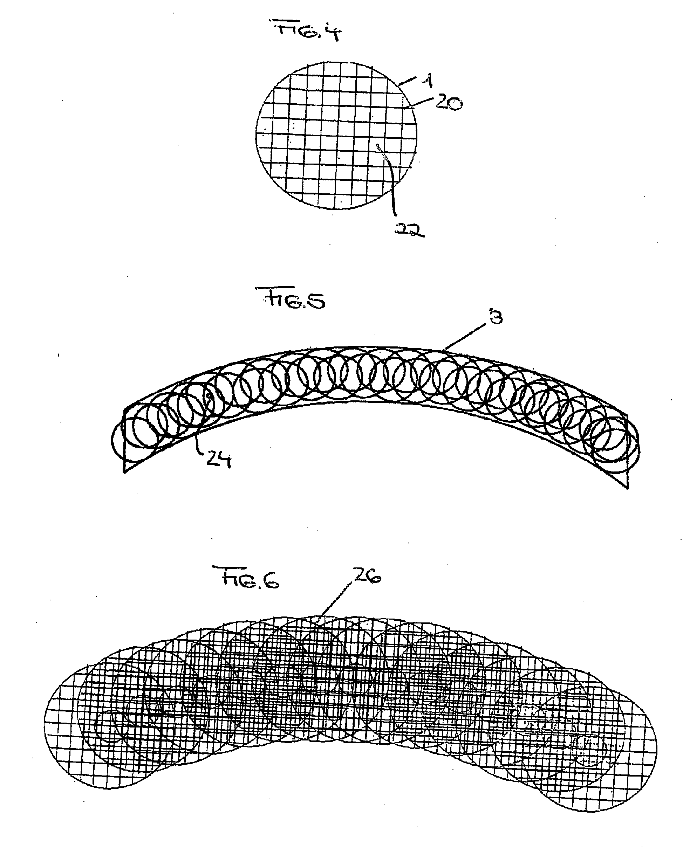

Bei der Gitternetztransformation wird jede zu einem Feldpunkt gehörende Pupille durch ein bestimmtes Netzgitter repräsentiert. Das Netzgitter wird entsprechend dem gewünschten Setting gewählt. Das Setting kann zum Beispiel ein Quadrupol oder annulares Setting sein. In Figur 4 ist ein derartiges Netzgitter 20 für eine kreisförmig ausgeleuchtete Pupille 1 gezeigt. Das Gitter 20 weist Zellen 22 gleicher Größe auf, wobei die gleiche Zellengröße gleiche Flächenleistungsdichte, d.h. Bestrahlungsstärke, bedeutet.

Entsprechend der Ausdehnung der hier nicht dargestellten Lichtquelle des Beleuchtungssystems, welche bei kritischer Beleuchtung in eine Feldebene abgebildet wird, und unter Berücksichtigung der Telezentrieanforderung in der Austrittspupille wird eine Anzahl von diskreten Feldpunkten gewählt, mit denen eine homogene Ausleuchtung der Pupille erzielt wird.

In Figur 5 sind die Feldpunkte durch eine Vielzahl von Lichtquellenbilder 24 in der Feldebene, in der das Ringfeldsegment 3 ausgebildet wird, dargestellt.

Das Netzgitter 20 der Pupillen wird über jeden Feldpunkt 24 in der Feldebene und eventuelle optische Komponenten, wie beispielsweise feldformende oder abbildende optische Komponenten, in die Ebene des erfindungsgemäßen facettierten bzw. spekularen Reflektors des optischen Elementes zurückverfolgt. Dort entsteht durch Überlagerung ein kompliziertes Netz, in dem verschiedene Knotenpunkte unterschiedlichen Feldpunkten zugeordnet sind. Dieses Netz wird als Facettennetz 26 bezeichnet. Ein derartiges Facettennetz 26 ist in Figur 6 gezeigt.

Auf dem spekularen Reflektor wird ein Transformationsnetz berechnet, wobei die Randbedingung gleiche Bestrahlungsstärke pro Zelle erfüllt wird. Das Facettennetz 26 wird auf das Transformationsnetz gelegt und beide werden so transformiert, daß das Transformationsnetz kartesisch, d.h. äquidistant und rechtwinklig, wird.

Um jeden Gitterpunkt des transformierten Facettennetzes wird nun eine Facette gezogen. Sodann wird das Facettennetz auf das Transformationsnetz zurücktransformiert. Es resultieren dann Facetten unterschiedlicher Größe und Position, deren Neigungswinkel durch einen zugeordneten Feldpunkt definiert ist. Der Neigungswinkel wird so eingestellt, daß der einfallende Strahl z. B. aus dem Zentrum der Lichtquelle in Richtung des zugeordneten Feldpunktes gelenkt wird.

In den verbleibenden Lücken schickt man die nicht nutzbare einfallende Strahlung durch bestimmte andere Facettenwinkel in einen Strahlensumpf oder man bringt keine Facetten an.

Dabei muß sich durch die Vielzahl der Facetten, die auf einen Feldpunkt Licht lenken, nicht unbedingt eine vollständig ausgeleuchtete Austrittspupille der gewünschten Form einstellen. Bei scannender Belichtung, d.h. Retikel-Maske und Wafer werden während der Belichtung synchron in oder entgegen der y-Richtung verfahren, ist es vielmehr ausreichend, wenn sich nach Scanintegration über eine bestimmte Feldhöhe x die gewünschte Ausleuchtung der Austrittspupille einstellt. Daher kann auch der Neigungswinkel jeder Facette so eingestellt werden, daß eine Vielzahl von Facetten jeweils einen anderen Feldpunkt beispielsweise innerhalb des auszuleuchtenden Feldes entlang des Scanwegs in y-Richtung ausleuchtet, so daß sich erst nach Scanintegration eine vollständig ausgeleuchtete Austrittspupille einstellt.

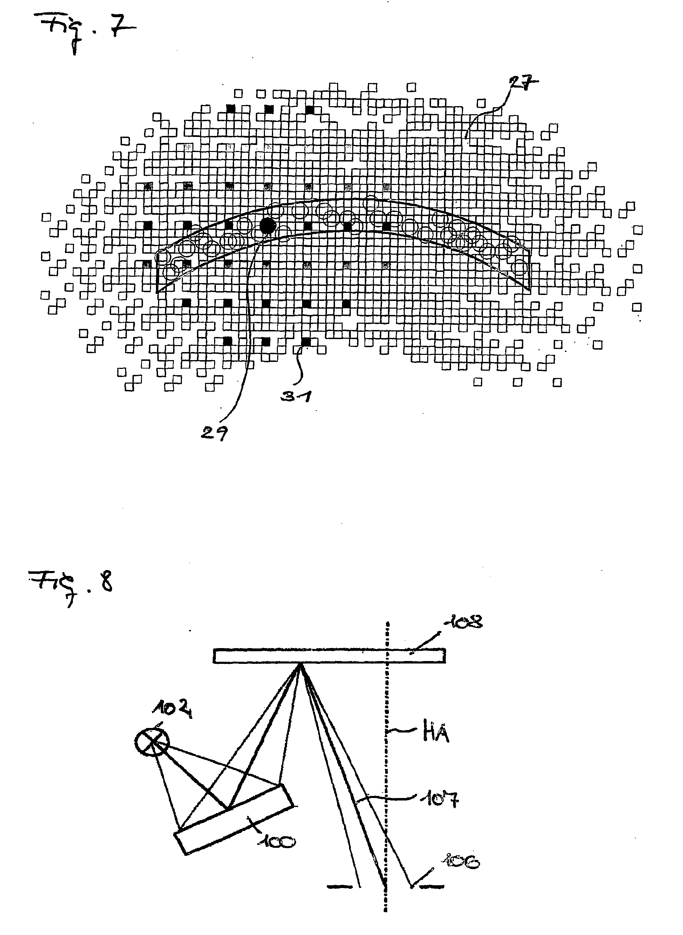

In Figur 7 ist das sich unter der Randbedingung gleicher Bestrahlungsstärke pro Zelle beispielsweise ergebende transformierte Transformationsnetz 27 ohne zusätzliche abbildende oder feldformende Komponenten gezeigt. Dargestellt ist eine Vielzahl von rechteckigen Facetten, welche über ihre individuellen Neigungswinkel jeweils eine Vielzahl von diskreten Feldpunkten und zugeordneter Pupillenorte ausleuchten. Gekennzeichnet in Figur 7 sind die auf den spekularen Reflektor zurückprojizierten Feldpunkte 29, wobei im Sinne der Anschaulichkeit die Kontur des ausgeleuchteten Feldes in das transformierte Transformationsnetz 27 skizziert ist. In Figur 7 ist ferner einer dieser zurückprojizierten Feldpunkte 29 hervorgehoben, um die diesem Feldpunkt zugeordneten Facetten 31, hier dunkel unterlegt, exemplarisch darstellen zu können.

In einem weiteren Schritt kann man eine Optimierung der Netzpunkte in der Pupille, zum Beispiel durch feldpunktabhängige Gestaltung des Netzes in der Pupille und dem Feld durch abweichende Wahl der Feldpunkte unter Berücksichtigung der Uniformität in Scanrichtung, vornehmen, so daß sich ein minimaler Lichtverlust im Strahlensumpf einstellt.

Zur Berechung der Uniformität in Scanrichtung wird von einer Ausleuchtung der Feldebene in der Form eines Ringfeldsegments gemäß Figur 3 ausgegangen. Im dargestellten Ringfeldsegment ist ein x,y-Koordinatensystem eingezeichnet, wobei die Scanrichtung parallel zur y-Richtung des Koordinatensystems verläuft. Die Scanenergie (SE) in Abhängigkeit der zur-Scanrichtung senkrechten Richtung x berechnet sich wie folgt:

$$SE(x) = \int E(x, y)\, dy$$

wobei E in Abhängigkeit von x und y die Intensitätsverteilung in der xy-Feldebene ist. Will man nun eine gleichmäßige Belichtung erhalten, so ist es vorteilhaft, wenn die Scanenergie weitgehend unabhängig von der x-Position ist. Die Uniformität in Scanrichtung ist demgemäß wie folgt definiert:

$$\text{Uniformität [\%]} = 100\% * (SE_{max} - SE_{min}) / (SE_{max} + SE_{min})$$

Dabei ist $SE_{max}$ die maximal und $SE_{min}$ die minimal auftretende Scanenergie im ausgeleuchteten Feldbereich.

Für eine verbesserte Ausleuchtung der Ausgangspupille des Beleuchtungssystems können auch zusätzlich die Facettenparameter des spekularen Reflektors so eingestellt werden, daß für jede Integration der Beleuchtungsanteile aller Punkte in der Feldebene, die auf einer in Scanrichtung verlaufenden Geraden liegen, die gleiche integrierte Teilbeleuchtung der Austrittspupille resultiert.

Mit dem erfindungsgemäßen optischen Element bzw. spekularen Reflektor, bei dem die Ablenkwinkel und die Anordnung der Facetten wie oben beschrieben gewählt, wurde, kann man Beleuchtungssysteme aufbauen, die nur mit wenigen, im Extremfall nur mit einer einzigen, optischen Komponente arbeiten. Da die Verluste durch Reflektion bei EUV-Strahlung erheblich sind, sind derartige Beleuchtungssysteme besonders vorteilhaft. Nachfolgend sollen beispielhaft Beleuchtungssysteme mit einem erfindungsgemäßen optischen Element näher beschrieben werden.

In Figur 8 ist ein erstes Beleuchtungssystem gemäß der Erfindung.gezeigt, bei dem das Beleuchtungssystem nur eine einzige optische Komponente umfaßt, nämlich das erfindungsgemäße facettierte optische Element bzw. den spekularen Reflektor 100, der gleichzeitig als Kollektor für das Licht der Lichtquelle 102 wirkt.

Der spekulare Reflektor 100 des einspiegeligen Beleuchtungssystems hat annähernd Nierenform und führt sowohl die Abbildung der Lichtquelle 102 in die Feldebene 108, die Ringfeldformung und die Ausleuchtung der Pupille 106 aus. Die Berechnung der Neigungswinkel und die Anordnung der Facetten erfolgt wieder über die Gitternetztransformation. Der spekulare Reflektor 100 gemäß Figur 8 umfaßt beispielsweise mehrere 1000 einzelne Facetten. Die Lage der Pupille kann in einem Projektionssystem durch den Schnittpunkt der optischen Achse HA des nachfolgenden Projektionsobjektives mit dem Schwerstrahl 107 eines Lichtbüschels zu einem Feldpunkt des auszuleuchtenden Feldes, beispielsweise dem mittleren Feldpunkt (0,0) bestimmt werden. Der Schwerstrahl ist dabei das energetische Mittel über alle Beleuchtungsstrahlen, welche durch einen Feldpunkt gehen. Bei den Projektionsbelichtungssystemen wie in Figur 8 beschrieben, fällt die Austrittspupille 106 des Beleuchtungssystems mit der Eintrittspupille des Projektionsobjektives zusammen.

Zur Formung der Ausleuchtung in der Pupille 106 kann es erforderlich sein, einzelne Facetten des spekularen Reflektors 100 mit Brechkraft auszustatten. Nimmt beispielsweise die Beleuchtungsstärke durch die Lichtquelle zu den Rändern nun ab, müssen dort die Facetten größer werden, um entsprechend mehr Licht einzusammeln. Dann ist es möglich, sie mit geringer Brechkraft auszustatten, damit in der Austrittspupille 106 wieder gleich groß ausgeleuchtete Punkte erhalten werden. In der Feldebene erhält man dadurch eine Verwaschung der kritischen Beleuchtung, was aber solange unerheblich ist, solange der Feldbereich nicht überstrahlt und damit Leistung verloren geht.

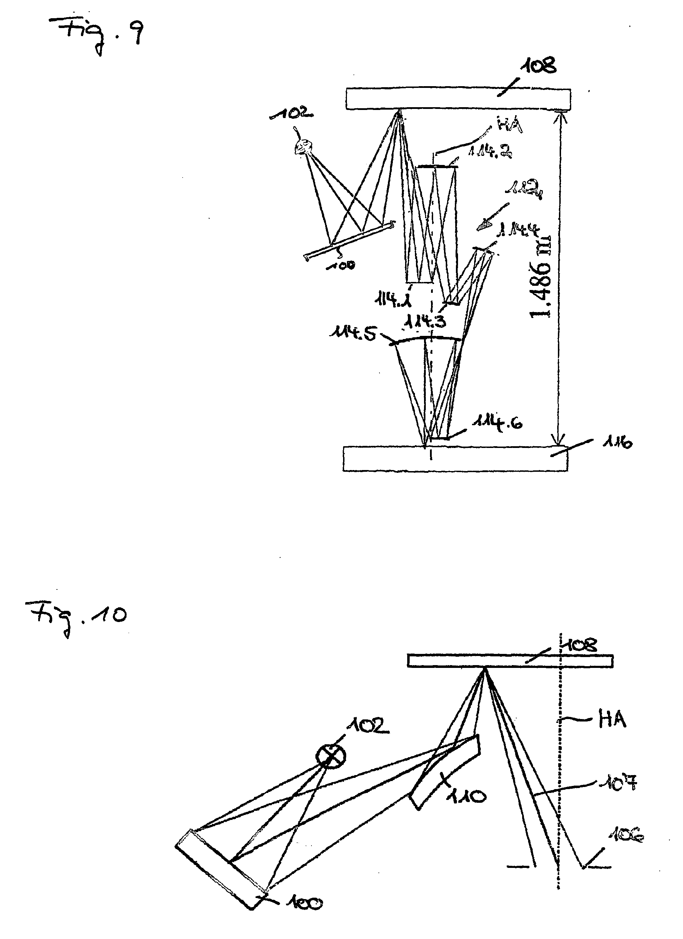

In Figur 9 ist eine Projektionsbelichtungsanlage mit einem Beleuchtungssystem aus Figur 8. gezeigt.

Bei der Projektionsbelichtungsanlage gemäß Figur 9 fällt die Austrittspupille 106 des Beleuchtungssystems gemäß Figur 8 mit der Eintrittspupille des nachfolgenden Projektionsbelichtungsobjektivs 112 zusammen. Das nachfolgende Projektionsobjektiv 112 ist ein 6-Spiegel-Projektionsobjektiv mit Spiegeln 114.1, 114.2, 114.3, 114.4, 114.5 und 114.6, wie beispielsweise in der US 6,353,470 offenbart, deren Offenbarungsgehalt vollumfänglich in die vorliegende Anmeldung mit aufgenommen wird. Die optische Achse des Projektionssystems ist mit HA bezeichnet. Anstelle eines 6-Spiegel Projektionsobjektives sind auch abbildende Systeme beispielsweise Projektionsobjektive mit mehr als 6-Spiegeln, die eine in der Feldebene angeordnete Maske auf ein lichtempfindliches Objekt projizieren denkbar. Nur beispielhaft sind hier ein 8-Spiegel-Projektionsobjektiv wie in der US-2002-0154395 A1 erwähnt. Eine Projektionsbelichtungsanlage mit einem Beleuchtungssystem wie in Figur 8 gezeigt mit einem 8-Spiegel-Projektionsobjektiv weist sowohl eine hohe Lichtleistung als auch sehr gute Abbildungseigenschaften auf.

Das Projektionsobjektiv 112 bildet eine in der Feldebene 108 angeordnete Maske, die auch als Retikel bezeichnet wird, in die Bildebene 196, in der ein lichtempfindliches Objekt, beispielsweise ein Wafer, angeordnet ist, ab. Sowohl die Maske wie das lichtempfindliche Objekt können in der Feld- bzw. Bildebene beweglich angeordnet sein, beispielsweise auf sogenannten Scantischen, die in Scanrichtung verfahrbar sind.

Zwar weist der nierenförmig auszulegende spekulare Reflektor 100 geometrische Lichtverluste auf; diese sind jedoch gering im Vergleich zu Beleuchtungssystemen mit mehreren Spiegeln. Bei Beleuchtungssystemen mit mehreren Spiegeln, treten sehr hohe Reflektionsverluste auf; beispielsweise weisen normal-incidence-Spiegel pro Spiegel weniger als 70% Reflektivität auf. Der nierenförmig auszulegende Reflektor beim Beleuchtungssystem gemäß Figur 8 entspricht in der Form im wesentlichen dem auszuleuchtenden Ringfeldsegment in der Feldebene.

In Figur 10 ist in einem weiteren Ausführungsbeispiel ein Beleuchtungssystem mit spekularem Reflektor 100 mit einem feldformenden Element 110 gezeigt. Gleiche -Bauteile wie in Figur 8 sind mit denselben Bezugsziffern belegt.

Der spekulare Reflektor 100 wird bei diesem Ausführungsbeispiel für ein rechteckiges Feld ausgelegt. Die Ringfeldformung erfolgt über das feldformende Element 110, das vorliegend ein feldformender grazing-indidence Spiegel ist. Zur Ausleuchtung eines Ringfeldsegments werden bevorzugt Feldspiegel mit konvexer Form verwendet.

Der spekulare Reflektor 100 besitzt in der Ausführungsform gemäß Figur 10 eine elliptische Form. Die Facetten haben beliebige Form und sind zum Beispiel durch eine Gitternetztransformation berechnet.

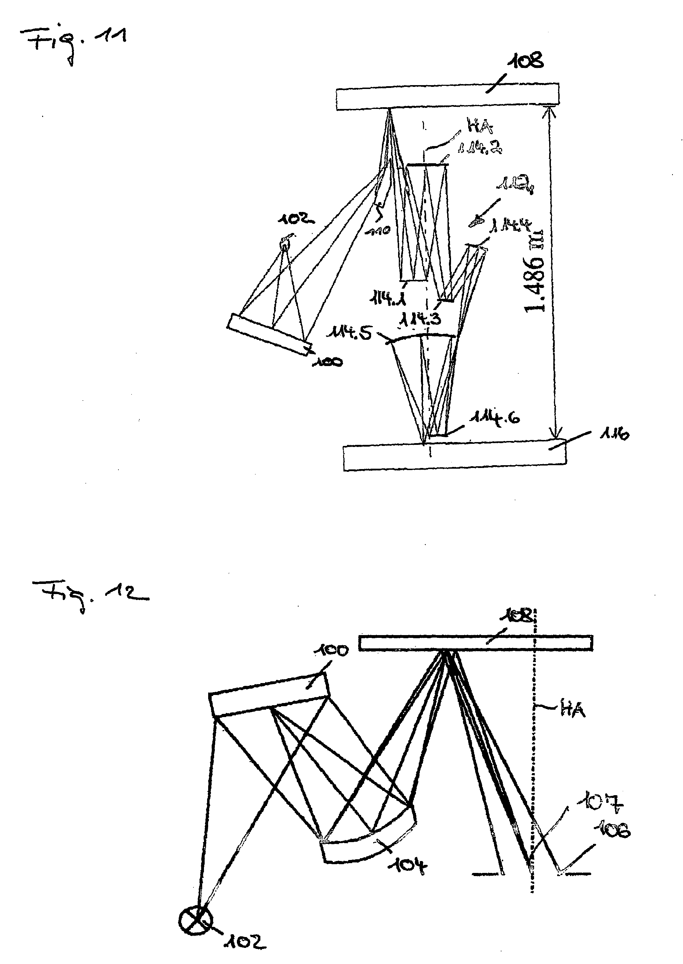

In Figur 11 ist eine Projektionsbelichtungsanlage mit einem Beleuchtungssystem gemäß Figur 10 gezeigt. Gleiche Bauteile wie in Figur 9 sind mit denselben Bezugsziffern belegt.

Bei der Ausführungsform gemäß Figur 8 bzw. Figur 10 können die Facettenspiegel des spekularen Reflektors zur Erhöhung der Kollektionsefhzienz auch auf einem gekrümmten Träger angeordnet werden. Die Lichtquelle 102 kann in einer weiteren Variante auch über einen abbildenden Kollektor gesammelt und mit einen zusätzlichen Spiegel in die Feldebene 108 abgebildet werden. Auch kann die Lichtquelle 102 ein Bild der Lichtquelle darstellen.

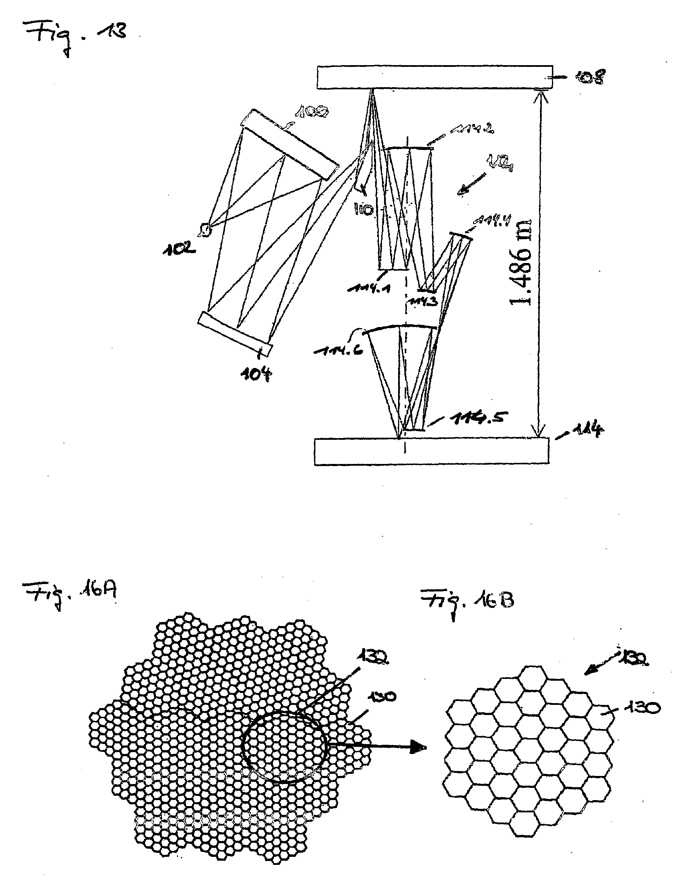

Alternativ kann ein Projektionsbelichtungssystem ein Beleuchtungssystem gemäß der Erfindung umfassen, das neben dem feldformenden Element zusätzlich ein oder mehrere abbildende Elemente 104 umfassen kann. Eine solches Beleuchtungssystem ist in Figur 12 dargestellt; während die entsprechende Projektionsbelichtungsanlage in Figur 13 gezeigt wird. Gleiche Bauteile wie in Figur 11 tragen dieselben Bezugsziffern.

Das Element mit abbildender Wirkung 104 bildet den spekularen Reflektor 100 in die Austrittspupille 106 des Beleuchtungssystems ab. Möglich sind selbstverständlich auch mehrere abbildende optische Elemente, welche gegebenenfalls sogar ein Zwischenbild des Ringfeldsegments 3 in der Feldebene 108 für den Einsatz von Blenden. Der Einsatz zusätzlicher abbildender oder anderer Spiegel kann vorteilhaft sein, wenn der Strahlengang zusätzlich gefaltet werden muß, um beispielsweise die Lichtquelle in einen besser zugänglichen Bauraum zu bringen. Dies ist in Figur 13 offensichtlich. Hier ist die Lichtquelle weiter entfernt von der Retikelmaske als im Vergleichsbeispiel der Figur 9.

Zusätzliche Spiegel zur Faltung des Strahlenganges sind besonders vorteilhaft für Lichtquellen, welche einen großen Bauraum beanspruchen.

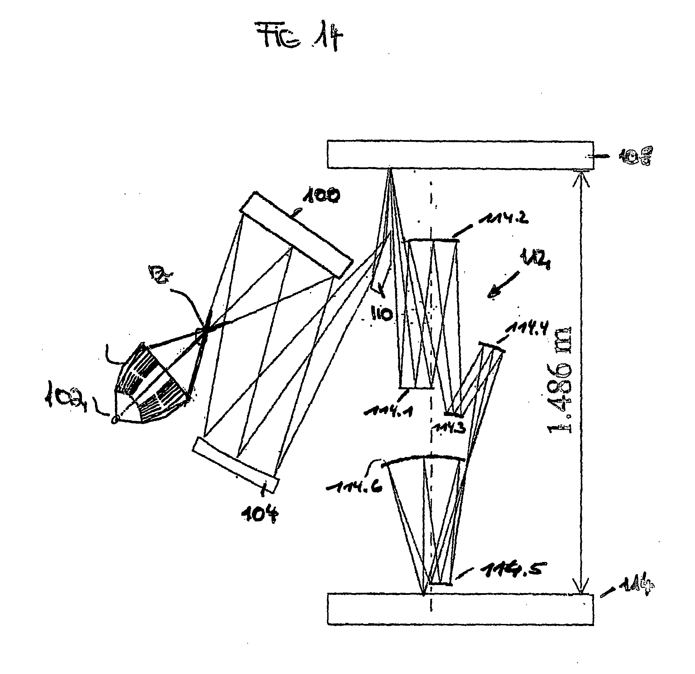

In Figur 14 ist ein System gemäß Figur 13 gezeigt, bei dem vom spekularen Reflektor nicht die Lichtquelle selbst sondern ein Bild Z der Lichtquelle aufgenommen wird. Das Bild Z der Lichtquelle wird durch eine Kollektoreinheit, beispielsweise einen genesteten grazing-incidence Kollektor 200, wie er in der US-2003-0043455 A1 offenbart ist, aufgenommen. Der spekulare Reflektor 100 der in Figur 14 gezeigten Anordnung nimmt das Licht des Zwischenbildes Z auf und bildet das Bild Z der Lichtquelle in die Feldebene 108 des Beleuchtungssystems ab.

Das Beleuchtungssystem gemäß Figur 14 entspricht in seinen andere Komponenten dem Beleuchtungssystem gemäß Figur 13. Gleiche Bauteile wie beim Beleuchtungssystem in Figur 13 tragen dieselben Bezugsziffern.

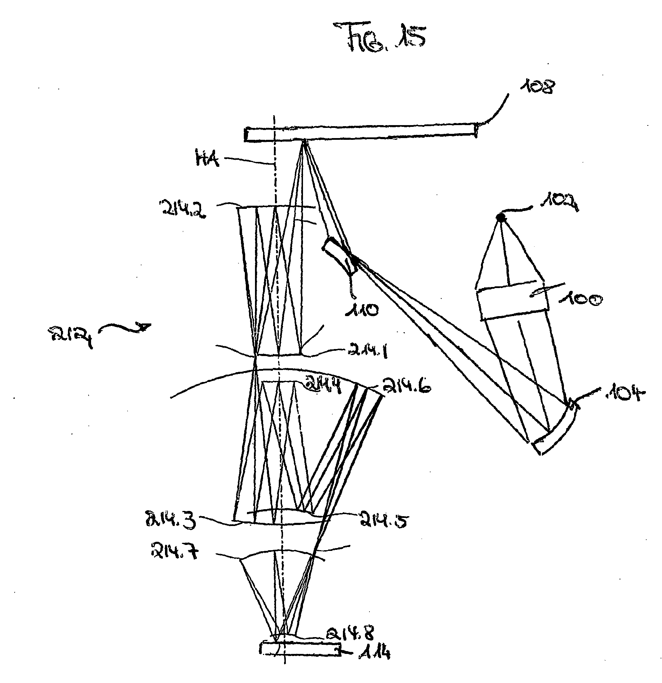

In Figur 15 ist ein Beleuchtungssystem gemäß Figur 14 gezeigt, bei dem anstelle eines 6-Spiegel-Projektionsobjektives 112 mit sechs Spiegeln 114.1, 114.2, 114.3, 114.4, 114.5, 114.6 ein 8-Spiegel-Objektiv wie es beispielsweise in der US-2002-0154395 A1 offenbart ist, als Projektionsobjektiv verwandt wird. Das 8-Spiegel-Projektionsobjektiv 212 umfasst 8-Spiegel 214.1, 214.2, 214.214.4, 214.5, 214.6, 214.7, 214.8.

Des weiteren eingezeichnet ist die optische Achse HA des 8-Spiegel Projektionsobjektives.

In sämtlichen in den Figuren 9 -15 dargestellten Systemen ist die optische Achse HA des Projektionsobjektives eingezeichnet. Die Austrittspupille eines Beleuchtungssystems, die mit der Eintrittspupille der Projektionsbelichtungsanlage zusammenfällt ist definiert als der Schnittpunkt der Schwerstrahlen zur verschiedenen Feldpunkten mit der optischen Achse HA. Dies ist besonders deutlich in den Figuren 8 und 10 zu sehen. Die Austrittspupille ist dort mit Bezugsziffer 106 gekennzeichnet. Selbstverständlich wäre es für den Fachmann möglich, ohne erfinderisch tätig zu werden, anstelle der reellen Pupille eine virtuelle Pupille vorzusehen. Dann ist der Hauptstrahlwinkel am Retikel negativ. Ein derartiges System ist in WO2004/010224 gezeigt.

Nachfolgend soll ein konkretes Ausführungsbeispiel eines erfindungsgemäßen facettierten optischen Elementes beschrieben werden.

Bei einer Telezentrieanforderung von 1 mrad und einer Schnittweite der Eintrittspupille, die als Länge des Schwerpunktstrahls zwischen Feldebene und Austrittspupille definiert ist, von etwa 1 m ergibt sich ein idealer Abstand der Lichtquellenbilder in der Feldebene 108 von < 2 mm. Dann ist der Telezentriefehler in der Austrittspupille 106 mit einem Punkt auf dem Feld in der Feldebene108 zwischen zwei gewählten Zielpunkten unterhalb 1 mrad. Auf dem facettierten optischen Element 100 sind mehr als 50 Zielpunkte erforderlich.

Legt man die Lichtquellenbilder größer aus, so sehen Feldpunkte zwischen den Zielpunkten immer Licht aus der Pupille zu mindestens zwei Zielpunkten. In diesem Fall wird die Telezentrie auch bei weniger Zielpunkten erfüllt, zum Beispiel bei 30 Zielpunkten. In den Figuren 16A und 16B ist für einen Ausschnitt des erfindungsgemäßen facettierten optischen Elementes ein solches mit hexagonalen Facetten dargestellt.

In Figur 16A ist das facettierte optische Element mit hexagonalen Facetten 130 beispielhaft gezeigt. Bezugsziffer 132 bezeichnet einen Ausschnitt des facettierten optischen Elementes. Wie Figur 16B zeigt, besteht das gesamte facettierte optische Element aus ähnlichen Zellen mit mindestens 30 einzelnen Facetten, welche einem Feldpunkt zugeordnet sind.

Rechnet man mit mehr als 50 Punkten für die Pupille, so benötigt man ein nicht abbildendes optisches Element mit etwa 2000 bis 5000 Facetten. Bei einem Spiegeldurchmesser von 250 mm kommt man also auf eine Facettengröße von etwa 5 x 5 mm$^2$ - also eine durchaus makroskopische Elementgröße.

Als Herstellverfahren zur Herstellung des in dieser Anmeldung beschriebenen spekularen Reflektors 100 kommen die nachfolgenden Verfahren in Betracht:

- die Grautonlithographie oder direktschreibende Lithographie in Verbindung mit Ätztechnik (RIE)
- das Zusammensetzen des spekularen Reflektors aus vielen kleinen Stäben, welche entsprechende Neigungswinkel an der Stirnseite aufweisen
- das galvanische Abformen (GA) eines nach obigen Methoden hergestellten Masters

Mit der vorliegenden Erfindung wird erstmals ein optisches Element angegeben, bei dem durch die Art der Anordnung der Facetten und der Ablenkwinkel der Facetten auf dem optischen Element die Feldebene und gleichzeitig die Austrittspupille ausgeleuchtet wird.

Des weiteren stellt die Erfindung ein Beleuchtungssystem zur Verfügung, das sich dadurch auszeichnet, daß es lediglich ein facettiertes optisches Element umfaßt.

Bezugszeichenliste

| | |
|---|---|
| 1 | Pupille, |
| 1.1, 1.2 | unterschiedliche Pupillenlagen |
| 3 | Ringfeldsegment |
| 5 | Ebene des facettierten optischen Elementes |
| 1.0 | Feldpunkt in der Mitte des Ringfeldsegments 3 |
| 12 | Feldpunkt am Rand des Ringfeldsegments 3 |
| 20 | Netzgitter |
| 22 | Zellen des Netzgitters |
| 24 | Feldpunkte in der Feldebene |
| 26 | Facettennetz |
| 27 | transformiertes Transformationsnetz |
| 29 | Feldpunkt, zurückprojiziert auf den spekularen Reflektor |
| 31 | zugeordnete Facette des facettierten optischen Elements |
| 100 | facettiertes optisches Element |
| 102 | Lichtquelle |
| 104 | abbildende Optik |
| 106 | Austrittspupille des Beleuchtungssystems |
| 107 | Schwerstrahl |
| 108 | Feldebene |
| 1110 | feldformendes optisches Element |
| 112 | Projektionsobjektiv |
| 114.1, 114.2 | |
| 114.3, 114.4 | |
| 114.5, 114.6 | Spiegel des 6-Spiegel-Projektionsobjektivs |
| 116 | Bildebene |
| 130 | hexagonale Facetten |
| 132 | Ausschnitt des facettierten, optischen Elements |
| 200 | genesteter Kollektor |
| 212 | 8-Spiegel-Projektionsobjektiv |
| 214.1, 214.2, | |
| 214.3, 214.4, | |
| 214.5, 214.6, | |
| 214.7, 214.8 | Spiegel des 8-Spiegel-Objektives |
| x-Richtung | Richtung in der Feldebene senkrecht zur Scanrichtung |
| y-Richtung | Richtung in der Feldebene in Scanrichtung |

**Patentansprüche**

1. Optisches Element (100) für ein Beleuchtungssystem mit Wellenlängen ≤ 193 nm; wobei das Beleuchtungssystem eine Lichtquelle (102), eine Feldebene (108) sowie eine Austrittspupille (106) aufweist; und das optische Element (100) eine Vielzahl von Facetten aufweist, die so angeordnet sind und solche Ablenkwinkel aufweisen, dass jede Facette Licht von der Lichtquelle (102) aufnimmt und auf einen zugeordneten, diskreten Punkt (24) in der Feldebene lenkt, wobei die diskreten Punkte derart gewählt sind, dass ein Feld in der Feldebene (108) in vorbestimmter Form ausgeleuchtet wird; und jede Facette über den jeweils zugeordneten, diskreten Punkt (24) in der Feldebene einen zugeordneten Bereich der Austrittspupille (106) des Beleuchtungssystems ausleuchtet; und das optische Element (100) eine Vielzahl von Lichtquellenbildern (24) im Wesentlichen in der Feldebene (108) erzeugt und das optische Element (100) annähernd eine Nierenform aufweist.

2. Optisches Element (100) gemäß Anspruch 1, **dadurch gekennzeichnet, dass** die Vielzahl von Facetten so angeordnet sind und solche Ablenkwinkel sowie solche Größen aufweisen, dass die integrierte Ausleuchtung der Austrittspupille (106), welche von Feldpunkten entlang eines Wegs in Scanrichtung resultiert, weitgehend homogen ist.

3. Optisches Element (100) gemäß Anspruch 2, **dadurch gekennzeichnet, dass** die integrierte Ausleuchtung der Austrittspupille (106), welche von Feldpunkten entlang eines beliebigen Wegs in Scanrichtung resultiert, vorzugsweise kreisrund oder dipolar oder quadrupolar oder annular ist.

4. Optisches Element (100) gemäß einem der Ansprüche 1 bis 3, **dadurch gekennzeichnet, dass** das Feld in der Feldebene (108) ein Ringfeldsegment ist, wobei die radiale Richtung in der Mitte des Ringfeldsegments eine Scanrichtung des Beleuchtungssystems definiert.

5. Optisches Element (100) gemäß Anspruch 4, **dadurch gekennzeichnet, dass** für jede Integration der Beleuchtungsanteile aller Punkte in der Feldebene, die auf einer in Scanrichtung verlaufenden Geraden liegen, die gleiche integrierte Teilbeleuchtung der Austrittspupille (106) resultiert.

6. Optisches Element (100) gemäß einem der Ansprüche 1 bis 5, **dadurch gekennzeichnet, dass** der Strahlengang von der Lichtquelle (102) zum optischen Element (100) kein weiteres optisches Element aufweist.

7. Optisches Element (100) gemäß einem der Ansprüche 1 bis 7, **dadurch gekennzeichnet, dass** die Ablenkwinkel der Facetten eine sammelnde Wirkung erzeugen.

8. Optisches Element (100) gemäß einem der Ansprüche 1 bis 7, **dadurch gekennzeichnet, dass** zumindest eine Facette eine optische Brechkraft aufweist.

9. Optisches Element (100) gemäß einem der Ansprüche 1 bis 7, **dadurch gekennzeichnet, dass** zumindest eine Facette des optischen Elementes (100) eine Planfacette ist.

10. Beleuchtungssystem für Wellenlängen ≤ 193 nm, insbesondere für die EUV-Lithographie, umfassend

    - eine Lichtquelle (102),
    - eine Feldebene (108),
    - ein facettiertes optisches Element (100),
    - eine Austrittspupille (106), wobei
    - das facettierte optische Element (100) eine Vielzahl von Facetten aufweist, die so angeordnet sind und einen solchen Ablenkwinkel aufweisen, dass jede Facette Licht von der Lichtquelle (102) aufnimmt und auf einen diskreten Punkt in der Feldebene lenkt,

    wobei

- die diskreten Punkte derart gewählt sind, dass ein Feld in der Feldebene (108) in vorbestimmter Form ausgeleuchtet wird;
- jede Facette über den jeweils zugeordneten, diskreten Punkt in der Feldebene (24) einen zugeordneten Bereich der Austrittspupille (106) des Beleuchtungssystems ausleuchtet; und
das facettierte optische Element (100) eine Vielzahl von Lichtquellenbildern. (24) im Wesentlichen in der Feldebene (108) erzeugt.

11. Beleuchtungssystem gemäß Anspruch 10, **dadurch gekennzeichnet, dass** die Vielzahl von Facetten so angeordnet sind und solche Ablenkwinkel sowie solche Größen aufweisen, dass die integrierte Ausleuchtung der Austrittspupille (106), welche von Feldpunkten entlang eines Wegs in Scanrichtung resultiert, weitgehend homogen ist.

12. Beleuchtungssystem gemäß Anspruch 11, **dadurch gekennzeichnet, dass** die integrierte Ausleuchtung der Austrittspupille (106), welche von Feldpunkten entlang eines beliebigen Wegs in Scanrichtung resultiert, vorzugsweise kreisrund oder quadrupolar oder annular ist.

13. Beleuchtungssystem gemäß einem der Ansprüche 10 bis 12, **dadurch gekennzeichnet, dass** das Feld in der Feldebene (108) ein Ringfeldsegment ist, wobei die radiale Richtung in der Mitte des Ringfeldsegments eine Scanrichtung des Beleuchtungssystems definiert.

14. Beleuchtungssystem gemäß Anspruch 13, **dadurch gekennzeichnet, dass** das facettierte optische Element (100) das Ringfeldsegment in der Feldebene (108) formt.

15. Beleuchtungssystem gemäß einem der Ansprüche 10 bis 14, **dadurch gekennzeichnet, dass** der Strahlengang von der Lichtquelle (102) zum facettierten optischen Element (100) kein weiteres optisches Element aufweist.

16. Beleuchtungssystem gemäß einem der Ansprüche 10 bis 15, **dadurch gekennzeichnet, dass** das Beleuchtungssystem des weiteren einen grazing-incidence Feldspiegel (110) zur Formung des Ringfeldsegments in der Feldebene (108) umfasst.

17. Beleuchtungssystem gemäß Anspruch 16, **dadurch gekennzeichnet, dass** der grazing-incidence Feldspiegel (110) eine konvexe Form aufweist.

18. Beleuchtungssystem gemäß einem der Ansprüche 10 bis 17, **dadurch gekennzeichnet, dass** das Beleuchtungssystem des Weiteren einen Konkav-Spiegel als abbildendes optisches Element (104) zur Abbildung des facettierten optischen Elementes (100) in die Austrittspupille (106) umfasst.

19. Beleuchtungssystem gemäß einem der Ansprüche 10 bis 18, **dadurch gekennzeichnet, dass** für jede Integration der Beleuchtungsanteile aller Punkte in der Feldebene, die auf einer in Scanrichtung verlaufenden Geraden liegen, die gleiche integrierte Teilbeleuchtung der Austrittspupille (106) resultiert.

20. Beleuchtungssystem gemäß einem der Ansprüche 10 bis 19, **dadurch gekennzeichnet, dass** das facettierte optische Element (100) austauschbar ist, so dass verschiedene Formen der Ausleuchtung in der Austrittspupille (106) erzeugt werden können.

21. Beleuchtungssystem nach Anspruch 10, **dadurch gekennzeichnet, dass** im Lichtweg vom facettierten optischen Element (100) zur Austrittspupille (106) keine optischen Elemente angeordnet sind, die das facettierte optische Element (100) in die Austrittspupille (106) abbilden.

22. Beleuchtungssystem gemäß Anspruch 21, wobei das facettierte optische Element (100) mehr als 1000 einzelne Facetten umfasst.

23. Beleuchtungssystem nach einem der Ansprüche 21 bis 22, wobei das facettierte optische Element (100) annähernd eine Nierenform aufweist.

24. Beleuchtungssystem nach einem der Ansprüche 21 bis 23, wobei das facettierte optische Element (100) eine Vielzahl von Facetten aufweist
und wobei die Facetten unterschiedliche Größen und unterschiedliche Positionen auf dem facettierten optischen Element (100) haben.

25. Projektionsbelichtungsanlage für die Mikrolithographie, insbesondere für Wellenlängen ≤ 193nm, insbesondere im EUV-Bereich mit einem Beleuchtungssystem gemäß wenigstens einem der Ansprüche 10 bis 24 und einem Projektionsobjektiv (112, 212)

26. Projektionsbelichtungsanlage für die Mikrolithographie, insbesondere für Wellenlängen ≤ 193nm, insbesondere für die EUV-Lithographie, gemäß Anspruch 25, **dadurch gekennzeichnet, dass** das Projektionsobjektiv (112, 212) mindestens sechs Spiegel (114.1, 114.2, 114.3, 114.4, 114.5, 114.6) aufweist.

27. Projektionsbelichtungsanlage gemäß einem der Ansprüche 25 bis 26, **dadurch gekennzeichnet, dass** das Projektionsobjektiv (112, 212) mindestens acht Spiegel (214.1, 214.2, 214.3, 214.4, 214.5, 214.6, 214.7, 214.8) umfasst.

28. Projektionsbelichtungsanlage gemäß einem der Ansprüche 25 bis 27, **dadurch gekennzeichnet, dass** die Eintrittspupille des Projektionsobjektives (112, 212) reell ist.

29. Projektionsbelichtungsanlage gemäß einem der Ansprüche 25 bis 27, **dadurch gekennzeichnet, dass** die Eintrittspupitte des Projektionsobjektives (112, 212) virtuell ist.

30. Projektionsbelichtungsanlage gemäß einem der Ansprüche 25 bis 29, **dadurch gekennzeichnet, dass** das Beleuchtungssystem eine Feldebene (108) der Projektionsbelichtungsanlage ausleuchtet, in der eine Maske angeordnet ist und das Projektionsobjektiv (112, 212) ein Bild der Maske auf ein lichtempfindliches Trägersubstrat abbildet, wobei auf dem Trägersubstrat ein lichtempfindliches Objekt angeordnet ist.

31. Verfahren zur Herstellung mikroelektronischer Bauteile, insbesondere Halbleiterchips, mit einer Projektionsbelichtungsanlage gemäß einem der Ansprüche 25 bis 30.

## Claims

1. An optical element (100) for an illumination system using wavelengths ≤ 193 nm; the illumination system having a light source (102), a field plane (108), and an exit pupil (106);
and
the optical element (100) having a plurality of facets, which are situated and have deflection angles such that each facet absorbs light from the light source (102) and deflects it onto an associated, discrete point (24) in the field plane, the discrete points being selected such that a field in the field plane (108) is illuminated in predetermined form; and each facet illuminating an associated area of the exit pupil (106) of the illumination system via the particular associated, discrete point (24) in the field plane; and
the optical element (100) generating a variety of light source images (24) essentially in the field plane (108) and the optical element (100) approximately having a kidney shape.

2. The optical element (100) according to Claim 1, **characterized in that** the plurality of facets are situated and have deflection angles and dimensions such that the integrated illumination of the exit pupil (106), which results from field points along a path in the scanning direction, is largely homogeneous.

3. The optical element (100) according to Claim 2, **characterized in that** the integrated illumination of the exit pupil (106), which results from field points along an arbitrary path in the scanning direction, is preferably circular or dipolar or quadrupolar or annular.

4. The optical element (100) according to one of Claims 1 through 3, **characterized in that** the field in the field plane (108) is a ring field segment, the radial direction in the center of the annular field segment defining a scanning direction of the illumination system.

5. The optical system (100) according to Claim 4, **characterized in that** upon each integration of the illumination components of all points in the field plane which lie on a straight line running in the scanning direction, the same integrated partial illumination of the exit pupil (106) results.

6. The optical element (100) according to one of Claims 1 through 5, **characterized in that** the beam path from the light source (102) to the optical element (100) has no further optical element.

**7.** The optical element (100) according to one of Claims 1 through 7, **characterized in that** the deflection angles of the facets generate a collecting effect.

**8.** The optical element (100) according to one of Claims 1 through 7, **characterized in that** at least one facet has an optical refractive power.

**9.** The optical element (100) according to one of Claims 1 through 7, **characterized in that** at least one facet of the optical element (100) is a planar facet.

**10.** An illumination system for wavelengths ≤ 193 nm, in particular for EUV lithography, comprising

- a light source (102),
- a field plane (108),
- a faceted optical element (100),
- an exit pupil (106),
- the faceted optical element (100) having a plurality of facets, which are situated and have deflection angles such that each facet absorbs light from the light source (102) and deflects it onto a discrete point in the field plane,
- the discrete points being selected such that a field in the field plane (108) is illuminated in predetermined form;
- each facet illuminating an associated area of the exit pupil (106) of the illumination system via the particular associated, discrete point in the field plane (24); and
- the faceted optical element (100) generating a plurality of light source images (24) essentially in the field plane (108).

**11.** The illumination system according to Claim 10, **characterized in that** the plurality of facets are situated and have deflection angles and dimensions such that the integrated illumination of the exit pupil (106), which results from field points along a path in the scanning direction, is extensively homogeneous.

**12.** The illumination system according to Claim 11, **characterized in that** the integrated illumination of the exit pupil (106), which results from field points along an arbitrary path in the scanning direction, is preferably circular or quadrupolar or annular.

**13.** The illumination system according to one of Claims 10 through 12, **characterized in that** the field in the field plane (108) is a ring field segment, the radial direction in the center of the ring field segment defining a scanning direction of the illumination system.

**14.** The illumination system according to Claim 13, **characterized in that** the faceted optical element (100) forms the ring field segment in the field plane (108).

**15.** The illumination system according to one of Claims 10 through 14, **characterized in that** the beam path from the light source (102) to the faceted optical element (100) has no further optical element.

**16.** The illumination system according to one of Claims 10 through 15, **characterized in that** the illumination system also comprises a grazing-incidence field mirror (110) for shaping the ring field segment in the field plane (108).

**17.** The illumination system according to Claim 16, **characterized in that** the grazing-incidence field mirror (110) has a convex shape.

**18.** The illumination system according to one of Claims 10 through 17, **characterized in that** the illumination system also comprises a concave mirror as an imaging optical element (104) for imaging the faceted optical element (100) in the exit pupil (106).

**19.** The illumination system according to one of Claims 10 through 18, **characterized in that** upon each integration of the illumination components of all points in the field plane, which lie on a straight line running in the scanning direction, the same integrated partial illumination of the exit pupil (106) results.

**20.** The illumination system according to one of Claims 10 through 19, **characterized in that** the faceted optical element (100) is replaceable, so that various shapes of the illumination in the exit pupil (106) may be generated.

21. The illumination system according to Claim 10, **characterized in that** no optical elements, which image the faceted optical element (100) in the exit pupil (106), are situated in the light path from the faceted optical element (100) to the exit pupil (106).

22. The illumination system according to Claim 21, wherein the faceted optical element (100) comprises more than 1000 individual facets.

23. The illumination system according to one of Claims 21 through 22, wherein the faceted optical element (100) approximately has a kidney shape.

24. The illumination system according to one of Claims 21 through 23, wherein the faceted optical element (100) has a plurality of facets, and the facets have different dimensions and different positions on the faceted optical element (100).

25. A projection exposure facility for microlithography, in particular for wavelengths ≤ 193 nm, in particular in the EUV range having an illumination system according to at least one of Claims 10 through 24 and a projection objective (112, 212).

26. The projection exposure facility for microlithography, in particular for wavelengths ≤ 193 nm, in particular for EUV lithography, according to Claim 25, **characterized in that** the projection objective (112, 212) has at least six mirrors (114.1, 114.2, 114.3, 114.4, 114.5, 114.6).

27. The projection exposure facility according to one of Claims 25 through 26, **characterized in that** the projection objective (112, 212) comprises at least eight mirrors (214.1, 214.2, 214.3, 214.4, 214.5, 214.6, 214.7, 214.8).

28. The projection exposure facility according to one of Claims 25 through 27, **characterized in that** the entry pupil of the projection objective (112, 212) is real.

29. The projection exposure facility according to one of Claims 25 through 27, **characterized in that** the entry pupil of the projection objective (112, 212) is virtual.

30. The projection exposure facility according to one of Claims 25 through 29, **characterized in that** the illumination system illuminates a field plane (108) of the projection exposure facility, in which a mask is situated, and the projection objective (112, 212) images an image of the mask on a light-sensitive carrier substrate, a light-sensitive object being situated on the carrier substrate.

31. A method for producing microelectronic components, in particular semiconductor chips, using a projection exposure facility according to one of Claims 25 through 30.

**Revendications**

1. Élément optique (100) pour un système d'éclairage avec des longueurs d'onde ≤ 193 nm,
   ledit système d'éclairage présentant une source lumineuse (102), un plan de champs (108) ainsi qu'une pupille de sortie (106) ;
   et
   ledit élément optique (100) présentant une multitude de facettes, qui sont disposées d'une telle manière et présentent de tels angles de déflexion que chaque facette reçoive de la lumière à partir de ladite source lumineuse (102) et la dirige vers un point discret associé (24) sur ledit plan de champs,
   lesdits points discrets étant choisis de sorte qu'un champ situé sur ledit plan de champs (108) soit éclairé sous une forme prédéterminée ;
   et chaque facette éclairant, par l'intermédiaire dudit point discret (24) associé à elle sur ledit plan de champs, une zone de ladite pupille de sortie (106) dudit système d'éclairage ; et
   ledit élément optique (100) générant une multitude d'images de source lumineuse (24), essentiellement sur ledit plan de champs (108), et ledit élément optique (100) présentant approximativement une forme d'un rein.

2. Élément optique (100) selon la revendication 1, **caractérisé en ceci que** ladite multitude des facettes est disposée d'une telle manière et présente de tels angles de déviation et de telles tailles que l'éclairage intégré de ladite pupille de sortie (106), lequel résulte à partir des points de champ le long d'un chemin en direction de scannage, soit largement homogène.

3. Élément optique (100) selon la revendication 2, **caractérisé en ceci que** ledit éclairage intégré de ladite pupille de sortie (106), lequel résulte à partir des points de champ le long d'un chemin quelconque en direction de scannage, est de préférence circulaire ou dipolaire ou quadripolaire ou annulaire.

4. Élément optique (100) selon l'une des revendications 1 à 3, **caractérisé en ceci que** ledit champ sur ledit plan de champs (108) est un segment de champ annulaire, le sens radial définissant une direction de scannage du système d'éclairage au milieu dudit segment de champ annulaire.

5. Élément optique (100) selon la revendication 4, **caractérisé en ceci que** , pour chaque intégration des parts d'éclairage de tous les points sur le plan de champs, qui sont situés sur une ligne droite en direction de scannage, il résulte un éclairage partiel intégré identique de ladite pupille de sortie (106).

6. Élément optique (100) selon l'une des revendications 1 à 5, **caractérisé en ceci que** le trajet des rayons à partir de ladite source lumineuse (102) vers ledit élément optique (100) ne présente aucun autre élément optique.

7. Élément optique (100) selon l'une des revendications 1 à 7, **caractérisé en ceci que** les angles de déflexion des facettes génèrent un effet collecteur.

8. Élément optique (100) selon l'une des revendications 1 à 7, **caractérisé en ceci qu'**au moins une des facettes présente un pouvoir convergent optique.

9. Élément optique (100) selon l'une des revendications 1 à 7, **caractérisé en ceci qu'**au moins une des facettes dudit élément optique (100) est une facette plane.

10. Système d'éclairage pour des longueurs d'onde de ≤ 193 nm, en particulier pour la lithographie EUV, comportant

    - une source lumineuse (102),
    - un plan de champs (108),
    - un élément optique (100) à facettes,
    - une pupille de sortie (106),
    - ledit élément optique (100) à facettes présentant une multitude de facettes, qui sont disposées d'une telle manière et présentent un tel angle de déflexion que chaque facette reçoive de la lumière à partir de ladite source lumineuse (102) et la dirige vers un point discret sur le plan de champs,
    - lesdits points discrets étant choisis de sorte qu'un champ sur ledit plan de champs (108) soit éclairé sous une forme prédéterminée,
    - chaque facette éclairant, par l'intermédiaire dudit point discret (24) associé à elle sur ledit plan de champs, une zone de ladite pupille de sortie (106) dudit système d'éclairage ;

et ledit élément optique (100) à facettes générant une multitude d'images de source lumière (24), essentiellement sur ledit plan de champs (108).

11. Système d'éclairage selon la revendication 10, **caractérisé en ceci que** ladite multitude de facettes est disposée d'une telle manière et présente de tels angles de déflexion et de telles tailles que l'éclairage intégré de ladite pupille de sortie (106), lequel résulte à partir des points de champ le long d'un chemin en direction de scannage, soit largement homogène.

12. Système d'éclairage selon la revendication 11, **caractérisé en ceci que** ledit éclairage intégré de ladite pupille de sortie (106), lequel résulte à partir des points de champ le long d'un chemin quelconque en direction de scannage, est de préférence circulaire ou dipolaire ou quadripolaire ou annulaire.

13. Système d'éclairage selon l'une des revendications 10 à 12, **caractérisé en ceci que** ledit champ sur ledit plan de champs (108) est un segment de champ annulaire, le sens radial définissant une direction de scannage du système d'éclairage au milieu dudit segment de champ annulaire.

**14.** Système d'éclairage selon la revendication 13, **caractérisé en ceci que** ledit élément optique (100) à facettes forme ledit segment de champ annulaire sur ledit plan de champs (108).

**15.** Système d'éclairage selon l'une des revendications 10 à 14, **caractérisé en ceci que** le trajet des rayons à partir de ladite source lumineuse (102) vers ledit élément optique (100) à facettes ne présente aucun autre élément optique.

**16.** Système d'éclairage selon l'une des revendications 10 à 15, **caractérisé en ce**ci que ledit système d'éclairage comporte en plus un miroir à champs en incidence rasante (110) pour former ledit segment de champ annulaire sur ledit plan de champs (108).

**17.** Système d'éclairage selon la revendication 16, **caractérisé en ceci que** ledit miroir à champs en incidence rasante (110) présente une forme convexe.

**18.** Système d'éclairage selon l'une des revendications 10 à 17, **caractérisé en ceci que** ledit système d'éclairage présente en plus un miroir concave en tant qu'élément optique de représentation (104) pour la représentation dudit élément optique (100) à facettes dans ladite pupille de sortie (106).

**19.** Système d'éclairage selon l'une des revendications 10 à 18, **caractérisé en ceci que** , pour chaque intégration des parts d'éclairage de tous les points sur le plan de champs, qui sont situés sur une ligne droite en direction de scannage, il résulte un éclairage partiel intégré identique de ladite pupille de sortie (106).

**20.** Système d'éclairage selon l'une des revendications 10 à 19, **caractérisé en ceci que** , ledit élément optique (100) à facettes est interchangeable de manière à ce que de différentes formes d'éclairage de ladite pupille de sortie (106) puissent être générées.

**21.** Système d'éclairage selon la revendication 10, **caractérisé en ceci que** , dans le chemin optique à partir dudit élément optique (100) à facettes vers ladite pupille de sortie (106), aucun élément optique, qui projette ledit élément optique (100) à facettes dans ladite pupille de sortie (106), n'est disposé.

**22.** Système d'éclairage selon la revendication 21, ledit élément optique (100) à facettes comportant plus de 1000 facettes individuelles.

**23.** Système d'éclairage selon l'une des revendications 21 à 22, ledit élément optique (100) à facettes présentant approximativement une forme d'un rein.

**24.** Système d'éclairage selon l'une des revendications 21 à 23, ledit élément optique (100) à facettes présentant une multitude de facettes, et lesdites facettes ayant de différentes tailles et différentes positions sur ledit élément optique (100) à facettes.

**25.** Dispositif d'exposition à la lumière projetée pour la micro-lithographie, en particulier pour les longueurs d'onde ≤193nm, en particulier dans le domaine EUV avec un système d'éclairage selon au moins une des revendications 10 à 24 et avec un objectif à projection (112, 212).

**26.** Dispositif d'exposition à la lumière projetée pour la micro-lithographie, particulier pour les longueurs d'onde ≤193nm, en particulier pour la lithographe EUV, selon la revendication 25, **caractérisé en ceci que** ledit objectif à projection (112, 212) présente au moins six miroirs (114.1, 114.2, 114.3, 114.4, 114.5, 114.6).

**27.** Dispositif d'exposition à la lumière projetée selon l'une des revendications 25 à 26, **caractérisé en ceci que** ledit objectif à projection (112, 212) présente au moins huit miroirs (214.1, 214.2, 214.3, 214.4, 214.5, 214.6, 214.7. 214.8).

**28.** Dispositif d'exposition à la lumière projetée selon l'une des revendications 25 à 27, **caractérisé en ceci que** la pupille d'entrée dudit objectif à projection (112, 212) est réelle.

**29.** Dispositif d'exposition à la lumière projetée selon l'une des revendications 25 à 27, **caractérisé en ceci que** ladite pupille d'entrée dudit objectif à projection (112, 212) est virtuelle.

**30.** Dispositif d'exposition à la lumière projetée selon l'une des revendications 25 à 29, **caractérisé en ceci que** ledit système d'éclairage éclaire un plan de champs (108) dudit dispositif d'exposition à la lumière projetée, sur lequel est disposé un masque et ledit objectif à projection (112, 212) projette une image dudit masque sur une sous-couche sensible à la lumière, un objet sensible à la lumière étant disposé sur ladite sous-couche.

**31.** Procédé pour la fabrication d'éléments micro-électroniques, en particulier de puces semi-conductrices, au moyen d'un dispositif d'exposition à la lumière projetée selon l'une des revendications 25 à 30.

FIG.1

FIG.2

Fig 3

FIG.4

FIG.5

FIG.6

Fig. 7

Fig. 8

Fig. 9

108

102

HA
114.2

112

114.4

1.486 m

114.1

114.3

114.5

114.6

116

Fig. 10

108

102

HA

110

107

100

106

Fig. 11

Fig. 12

Fig. 13

Fig. 16A

Fig. 16B

EP 1 614 008 B1

Fig. 14

25

FIG. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5339346 A
- US 5737137 A
- US 5361292 A
- US 5581605 A
- US 4195913 A
- US 4289380 A
- US 4202605 A
- US 5485498 A
- DE 19903807 A1
- US 6198793 B
- DE 19903807

- EP 1026547 A
- EP 1262836 A
- EP 1024408 A
- EP 1072957 A2
- US 20030043455 A1
- DE 10053587
- US 6658084 B
- US 6353470 B
- US 20020154395 A1
- WO 2004010224 A